# EUROPEAN PATENT SPECIFICATION

(11) **EP 2 765 480 B1**
(45) Date of publication and mention of the grant of the patent: **14.04.2021**
(21) Application number: 13382038.1
(22) Date of filing: 08.02.2013
(51) Int. Cl.: G06F 1/20, H05K 7/20

(54) **Server cooling system and method for cooling**
Serverkühlsystem und Verfahren zur Kühlung
Système de refroidissement pour serveur et procédé de refroidissement

(43) Date of publication of application: 13.08.2014
(73) Proprietor: PSH Energia, S.A., 28021 Madrid (ES)
(72) Inventor: ROMANOS TABUENCA, David, 28021 Madrid (ES)
(74) Representative: Mato Adrover, Ángel Luis

(56) References cited:
- US-A1- 2007 044 493
- US-A1- 2009 080 173
- US-A1- 2009 154 096

## Description

### OBJECT OF THE INVENTION

The object of the present invention, as indicated in the title of the invention, relates to a cooling system for servers, as well as the method for cooling, wherein the system comprises an evaporator, a condenser, an expansion valve and a compressor, wherein the evaporator has thermal communication with the server in a way that absorbs the heat generated by the server.

An inlet end of the condenser is connected to the outlet end of a compressor by means of tubes. In turn, the inlet end of the compressor is connected to the outlet end of the evaporator. The inlet end of the evaporator is connected to the outlet end of an electronic expansion valve. The inlet end of the electronic expansion valve is connected by means of tubes to the outlet of the condenser.

The system uses a refrigerant fluid for the use of compressors in the fluid line. The refrigerant fluid absorbs the heat generated by the server in the evaporator, changing phase from liquid to gas. Upon passing through the compressor, the refrigerant increases in pressure and temperature. Subsequently, the refrigerant circulates through the condenser and releases the heat to the exterior while the refrigerant decreases in pressure and temperature and changes phase from gas to liquid. In the next stage, the refrigerant passes through an expansion valve wherein the pressure and temperature are reduced right at the moment in which the refrigerant passes through the evaporator battery. At this last point, the temperature of the refrigerant is controlled so that the air that passes through the battery does not drop below the dew point and that there is no condensation of water in the Data Center.

The present invention falls within the field of cooling systems in general and more specifically, within cooling systems and methods for servers installed in Data Centers.

### BACKGROUND OF THE INVENTION

The cooling systems for Data Centers are known and commonly used for cooling computer servers and other electronic equipment present in Data Center rooms. Such equipment is designed to maintain specific temperatures and humidity levels that prevent said equipment from overheating and malfunctioning.

Typical Data Centers use complex CRAC (Computer Room Air Conditioning) systems. In general, the CRAC systems take hot air coming from the Data Centers and they return it cold to maintain the air in the room within a range of defined temperature and relative humidity. In any case, such air conditioning units demand great amounts of energy and are relatively inefficient, increasing operational costs. In many cases, cooling systems consume an equal amount, if not more, than the electronic equipment themselves that they cool.

As an alternative to the conventional cooling systems, the designers of Data Centers have developed different systems to reduce energy consumption, that do not require cooling. Examples of these systems that do not use refrigerant and of low energy consumption have "economizers" on the side of the air and of the water. They may be used in many cases but a number of problems are associated with them. For example, the "air economizers" that use air from the exterior have problems related to the quality of the air, introducing corrosives, dirt or dust. It is also difficult to control the relative humidity. In turn, the "water economizers" have problems associated with the presence of water in the Data Processing Center rooms due to the possibility of leaks that affect the electronic equipment. There are also problems of freezing in Towers during winter time as well as a considerable consumption of water.

Also known, are high-density cooling systems that must dissipate thermal loads of cabinets of over 12 - 15 kW, cascade systems are used and comprise: a primary (or secondary) cooling system together with a secondary (or primary) cold water (H₂O) circuit. These systems have the inherent drawbacks of the low density solution of the water used in the previously mentioned data rooms. In addition, these solutions are not very efficient because the cooling circuit has a great difference between the condensation temperature and evaporation temperature together with the losses in the heat exchange between the primary and secondary circuits. Another great disadvantage is the appearance of condensed water in the evaporator, in the Data Processing Control room, when refrigerant temperatures below the dew point are used.

Consequently, there is a need for systems that allow for avoiding the risks associated with the use of water in the Data Centers and that simultaneously increase the efficiency of the system.

It is known in the state of the art document US 2009080173 which discloses a vapor-compression heat exchange system for facilitating cooling of an electronics rack.

In US 2009154096 an apparatus and method are provided for facilitating air-cooling of an electronics system employing a vapor-compression heat exchange system, and front and back covers. An evaporator housing of the heat exchange system is mounted to a system housing of the electronics system and extends at least partially between air inlet and outlet sides of the system housing.

In US2007044493 are disclosed Systems and Methods of cooling heat generating electronics components are provided employing vapor compression refrigeration.

Therefore, the object of the present invention is to develop a cooling system for servers that overcomes the mentioned drawbacks of a high energy demand, inefficiency, high operational costs, problems related with the quality of air introducing corrosives, dirt or dust, difficulty in controlling the relative humidity, possibility of leaks, problems associated with presence of water, problems of the Cooling Towers freezing, inherent disadvantages of using the water in the Data rooms, inefficiency due to the difference between the temperature of condensation and the temperature of evaporation, for which, a cooling system such as that which will be described below, is developed and is reflected in its essentiality in the first claim.

### DESCRIPTION OF THE INVENTION

The cooling system for servers according to the present invention comprises:
- An evaporator that has an inlet and outlet. The evaporator is in thermal communication with a server to be cooled in a way that the evaporator absorbs the heat generated by the server.
- A compressor
- A condenser
- An expansion valve

Wherein the outlet of the evaporator is connected by a conduit to the inlet of the compressor, the outlet of the compressor is connected to the inlet of the condenser, and the outlet of the latter is connected to the inlet of the expansion valve and its outlet with the inlet of the evaporator, all connections being made by means of a conduit or tube.

The refrigerant fluid absorbs the heat generated by the server in the evaporator, changing phase from liquid to gas. Upon passing through the compressor, the refrigerant increases in pressure and temperature. Subsequently, the refrigerant circulates through the condenser and releases the heat to the exterior while the refrigerant decreases in pressure and temperature and changes phase from gas to liquid. In the next stage, the refrigerant passes through an expansion valve where it reduces in pressure and temperature right at the moment in which the refrigerant passes through the evaporator battery. At this last point, the temperature of the refrigerant is controlled so that the air that passes through the battery does not drop below the dew point and that there is no condensation of water in the Data Center.

Thanks to the means employed, its arrangement and connectivity, a cooling system for servers is achieved in which the energy requirement for the cooling cycle is much lower than other said systems and is safer in the room, as it avoids the presence of water, furthermore, by using a very high evaporation temperature ≥ 14°C, condensation of water is not produced in the battery, resulting in lower energy consumption.

### EXPLANATION OF THE FIGURE

To complete the description that is being made and with the aim of aiding a better understanding of the characteristics of the invention, according to a preferred embodiment thereof, attached as an integral part of said description is a figure wherein by way of non-limitative example, the following has been represented.

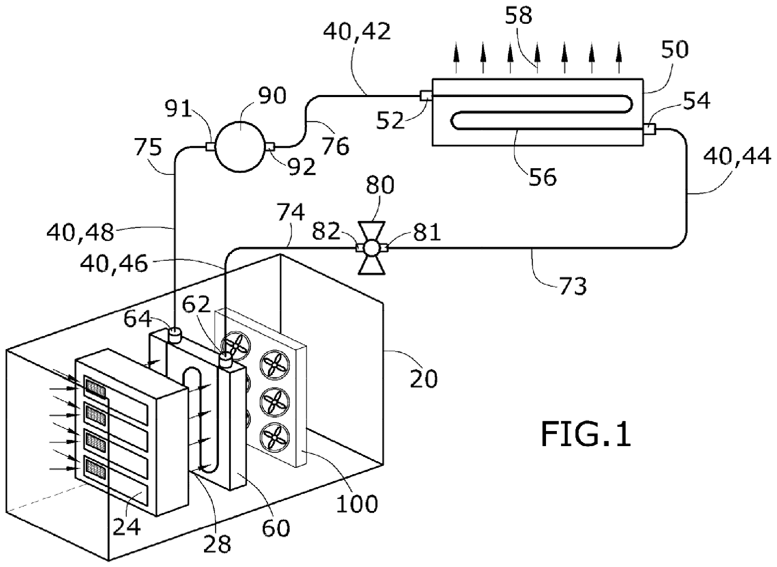

Figure 1.- Shows a schematic representation of the cooling system for servers wherein the elements that form part of the system and the interconnection can be seen.

### PREFERRED EMBODIMENT OF THE INVENTION

In view of the figure, below is a description of a preferred embodiment of the proposed invention.

The cooling system can be seen in Figure 1, wherein a set of servers 24 are shown, located inside a Data Center 20. Although they will be described in more detail later, the system includes a thermodynamic cycle, in which the refrigerant fluid 40 circulates, including a compressor 90 and an electronic expansion valve 80.

The cooling system comprises:
- a condenser 50,
- an evaporator 60,
- an expansion valve 80 and
- a compressor 90.

The outlet 64 of the evaporator 60 is connected to the inlet 91 of the compressor 90 by means of a tube or conduit 75. The outlet 92 of the compressor 90 is connected to the inlet 52 of the condenser 50 by means of the tube 76. In addition, the outlet 54 of the condenser 50 is connected to the inlet 81 of the electronic expansion valve 80 by means of the tube or conduit 73. While the outlet 82 of the electronic expansion valve is connected to the inlet 62 of the evaporator 60 by means of the tube 74.

Practically all of the heat given off by the server is absorbed by the evaporator without substantial losses (represented by the arrows 28), for which the evaporator can be considered directly communicated with the server. The discharge of heat of the rear part of the servers 24 is directly conducted to the evaporator without intermediate means (such as the air of the room, etc.). Other arrangements of the evaporator are possible, such as positioning the evaporator on top of the servers.

In operation, the condenser 50 supplies working fluid 40 in liquid state 44 to the electronic expansion valve 80 through the tube 73. This expansion valve 80 regulates the amount of refrigerant necessary so that in the outlet 64 of the evaporator, the working fluid is in gas phase 48, once the heat of the servers 28 has been absorbed in the evaporator. Subsequently, this refrigerant 40 is compressed in the compressor 90 in order to increase its temperature, changing phase 42. The pressure and temperature of the refrigerant 40 (phase 42) at the outlet 92 being higher than the pressure and temperature of the refrigerant 40 (phase 48) at the inlet 91. The refrigerant 40 is passed to the inlet 52 of the condenser 50 by means of a tube 76 where it passes from gas state 42 to liquid state 44 at the outlet 54 of the condenser 50.

In the condenser 50, the heat, represented by the arrows 58, passes from the refrigerant 40 medium to an appropriate refrigerant medium (for example, air or water). The amount of heat released by the refrigerant 40 in the vapor phase 42 causes the refrigerant, after passing through the condenser, to be in liquid phase (state 44). Subsequently, the refrigerant 40 in state 44 passes to the expansion valve 80 where it changes to state 46, at a lower temperature and pressure. Subsequently, the refrigerant reaches the evaporator 60 via the tube 74 where it enters through the inlet 62. Once the heat of the servers 28 passes on to the refrigerant 40 in the evaporator the refrigerant 40 changes to gas state 48 when it leaves the evaporator at the outlet 64.

In order for the heat of the servers 28 to pass through the evaporator battery, ventilators 100 with variable speed (depending on the heat to be dissipated and on the air flow expelled from the server ventilators) are used. The outlet 64 is joined to the inlet 91 of the compressor 90 by means of the tube 75. In this way, the cooling cycle is completed.

As the evaporator battery is located very close to the servers, an evaporation temperature (state 44) can be used, much higher than other systems that have a primary and secondary cascade circuit. This causes the energy requirement of the cooling cycle to be much lower than said systems.

Additionally, by using a very high evaporation temperature ≥ 14°C, condensation of water is not produced in the battery, resulting in a lower energy consumption (because it is not necessary to provide more water vapor to maintain the relative humidity of the room) and being safer in the room because the presence of water is avoided altogether, as the presence of water implies great risks for electronic equipment.

As the evaporator battery is next to the electronic equipment, the arrangement of the servers 24 in the room 20 is indifferent.

In the event that an increase in energy dissipated by the servers is required, in the majority of cases, only the rotation speed of the ventilators has to be increased.

Other additional advantages are related to the selection of the refrigerant 40 chosen. According to the refrigerant chosen, the refrigerant may have change of phase at moderate temperatures and pressures, typically a little greater than the atmospheric pressure. These moderate pressures avoid the use of equipment that has high pressure in tubes, evaporators, condensers, which results in the complexity and cost of the installation.

The fact that water is not used means that the use of detection equipment, pipes, drains, etc. is avoided.

Another advantage is that in the majority of cases, not having leaks between the servers (sources of heat) and the evaporators, avoids the use of room cooling systems or at least significantly reduces their power.

Having sufficiently described the nature of the present invention, as well as the way it put into practice, it should be noted that, within its essentiality, it may be put into practice in other embodiments which differ in detail from that indicated by way of example, and which to the protection sought will equally apply, provided that its fundamental principle is not altered, changed or modified.

## Claims

1. A server cooling system which comprises:
- a condenser (50),
- an evaporator (60),
- an expansion valve (80) and
- a compressor (90), wherein:
an outlet (64) of the evaporator (60) is connected to an inlet (91) of the compressor (90) by means of a first tube or conduit (75); an outlet (92) of the compressor (90) is connected to an inlet (52) of the condenser (50) by means of a second conduit (76); an outlet (54) of the condenser (50) is connected to the inlet (81) of an expansion valve (80) by means of a third tube or conduit (73), while the outlet (82) of the expansion valve (80) is connected to the inlet (62) of the evaporator (60) by means of a fourth conduit (74);
wherein
- the expansion valve (80) is an electronic expansion valve which regulates the amount of refrigerant so that in the outlet (64) of the evaporator, the working fluid is in gas phase (48);
- the evaporation temperature used in the evaporator is ≥ 14°C, therefore condensation of water is not produced in the evaporator, resulting in lower energy consumption; **characterised in that** connected to the evaporator are some ventilators with variable speed depending on the heat to be dissipated and on the air flow expelled from server ventilators.

2. Server cooling system, according to claim 1, **characterized in that** the evaporator is next to the servers to be cooled.

3. Server cooling system, according to claim 1, **characterized in that** the evaporator (60) is arranged on top of the servers.

4. Cooling method for the system of any of claims 1-3, **characterized in that** it comprises the following stages:
- Supplying a working fluid (40) in liquid state (44) from the condenser (50) to the electronic expansion valve (80) via the third conduit or tube (73);
- Regulating the amount of refrigerant by means of the electronic expansion valve (80) so that at the outlet (64) of the evaporator, the working fluid is in gas phase (48), once the heat of the servers (28) has been absorbed in the evaporator, the evaporation temperature used in the evaporator being ≥ 14° C, so that condensation of water is not produced in the evaporator; ventilators connected to the evaporator operating with variable speed depending on the heat to be dissipated and on the air flow expelled from server ventilators;
- Subsequently, the refrigerant (40) coming from the evaporator (60) is compressed in the compressor (90) in order to increase its temperature, changing to a gas state (42), the pressure and temperature of the refrigerant (40) at the outlet (92) of the compressor being higher than the pressure and temperature of the refrigerant (40) at the inlet (91) of the compressor (90);
- the refrigerant (40) reaches the inlet (52) of the condenser (50) via the second conduit or tube (76) where it changes from gas state (42) to liquid state (44) at the outlet (54) of the condenser.

## Patentansprüche

1. Serverkühlsystem, das Folgendes umfasst:
- einen Kondensator (50),
- einen Verdampfer (60),
- ein Expansionsventil (80) und
- einen Kompressor (90), wobei:
ein Auslass (64) des Verdampfers (60) mittels eines ersten Rohrs oder einer ersten Leitung (75) mit einem Einlass (91) des Kompressors (90) verbunden ist; ein Auslass (92) des Kompressors (90) mittels einer zweiten Leitung (76) mit einem Einlass (52) des Kondensators (50) verbunden ist; ein Auslass (54) des Kondensators (50) mittels eines dritten Rohrs oder einer dritten Leitung (73) mit dem Einlass (81) eines Expansionsventils (80) verbunden ist, während der Auslass (82) des Expansionsventils (80) mittels einer vierten Leitung (74) mit dem Einlass (62) des Verdampfers (60) verbunden ist; wobei
- das Expansionsventil (80) ein elektronisches Expansionsventil ist, das die Kältemittelmenge so regelt, dass sich das Arbeitsfluid im Auslass (64) des Verdampfers in der Gasphase (48) befindet;
- die im Verdampfer verwendete Verdampfungstemperatur ≥ 14 °C beträgt, sodass im Verdampfer keine Kondensation von Wasser erzeugt wird, was zu einem geringeren Energieverbrauch führt; **dadurch gekennzeichnet, dass** mit dem Verdampfer einige Ventilatoren mit variabler Drehzahl verbunden sind, die von der abzuleitenden Wärme und dem Luftstrom abhängt, der aus den Serverventilatoren ausgestoßen wird.

2. Serverkühlsystem, nach Anspruch 1, **dadurch gekennzeichnet, dass** sich der Verdampfer neben den zu kühlenden Servern befindet.

3. Serverkühlsystem, nach Anspruch 1, **dadurch gekennzeichnet, dass** der Verdampfer (60) auf den Servern angeordnet ist.

4. Kühlverfahren für das System nach einem der Ansprüche 1 bis 3, **dadurch gekennzeichnet, dass** es folgende Stufen umfasst:
- Zuführen eines Arbeitsfluids (40) in flüssigem Zustand (44) vom Kondensator (50) zum elektronischen Expansionsventil (80) über die dritte Leitung oder das dritte Rohr (73);
- Regeln der Kältemittelmenge mittels des elektronischen Expansionsventils (80), so dass sich das Arbeitsfluid am Auslass (64) des Verdampfers in der Gasphase (48) befindet, wobei, sobald die Wärme der Server (28) im Verdampfer absorbiert wurde, die im Verdampfer verwendete Verdampfungstemperatur ≥ 14 °C beträgt, so dass im Verdampfer keine Kondensation von Wasser erzeugt wird; mit dem Verdampfer verbundene Ventilatoren mit variabler Drehzahl arbeiten, die von der abzuleitenden Wärme und dem Luftstrom abhängt, der von den Server-Ventilatoren ausgestoßen wird;
- wobei das aus dem Verdampfer (60) kommende Kältemittel (40) im Kompressor (90) komprimiert wird, um seine Temperatur zu erhöhen und in einen Gaszustand (42) zu wechseln, der Druck und die Temperatur des Kältemittels (40) am Auslass (92) des Kompressors höher sind als der Druck und die Temperatur des Kältemittels (40) am Einlass (91) des Kompressors (90);
- das Kältemittel (40) über die zweite Leitung oder das zweite Rohr (76) zum Einlass (52) des Kondensators (50) gelangt, wo es am Auslass (54) des Kondensators vom Gaszustand (42) in den flüssigen Zustand (44) wechselt.

## Revendications

1. Système de refroidissement de serveur qui comprend :
- un condenseur (50),
- un évaporateur (60),
- une soupape de détente (80) et
- un compresseur (90), dans lequel :
une sortie (64) de l'évaporateur (60) est raccordée à une entrée (91) du compresseur (90) au moyen d'un premier tube ou conduit (75) ; une sortie (92) du compresseur (90) est raccordée à une entrée (52) du condenseur (50) au moyen d'un deuxième conduit (76) ; une sortie (54) du condenseur (50) est raccordée à l'entrée (81) d'une soupape de détente (80) au moyen d'un troisième tube ou conduit (73), tandis que la sortie (82) de la soupape de détente (80) est raccordée à l'entrée (62) de l'évaporateur (60) au moyen d'un quatrième conduit (74) ;
dans lequel
- la soupape de détente (80) est une soupape de détente électronique qui régule la quantité de réfrigérant de sorte que dans la sortie (64) de l'évaporateur, le fluide de travail est en phase gazeuse (48) ;
- la température d'évaporation utilisée dans l'évaporateur est ≥ 14 °C, la condensation d'eau ne se produit donc pas dans l'évaporateur, qui a pour résultat une plus faible consommation d'énergie ; **caractérisé en ce qu'**il y a, raccordés à l'évaporateur, des ventilateurs à vitesse variable en fonction de la chaleur à dissiper et du débit d'air expulsé des ventilateurs de serveur.

2. Système de refroidissement de serveur, selon la revendication 1, **caractérisé en ce que** l'évaporateur est à proximité des serveurs à refroidir.

3. Système de refroidissement de serveur, selon la revendication 1, **caractérisé en ce que** l'évaporateur (60) est disposé au-dessus des serveurs.

4. Procédé de refroidissement du système selon l'une quelconque des revendications 1 à 3, **caractérisé en ce qu'il** comprend les étapes suivantes :
- Fournir un fluide de travail (40) à l'état liquide (44) du condenseur (50) à la soupape de détente électronique (80) à travers le troisième conduit ou tube (73) ;
- Réguler la quantité de réfrigérant au moyen de la soupape de détente électronique (80) de sorte qu'à la sortie (64) de l'évaporateur, le fluide de travail est en phase gazeuse (48), une fois que la chaleur des serveurs (28) a été absorbée dans l'évaporateur, la température d'évaporation utilisée dans l'évaporateur étant ≥ 14 °C, de sorte à ne pas produire de condensation d'eau dans l'évaporateur ; des ventilateurs raccordés à l'évaporateur fonctionnant à vitesse variable en fonction de la chaleur à dissiper et du débit d'air expulsé des ventilateurs de serveur ;
- Par la suite, le réfrigérant (40) provenant de l'évaporateur (60) est comprimé dans le compresseur (90) afin d'augmenter sa température en passant à un état gazeux (42), la pression et la température du réfrigérant (40) à la sortie (92) du compresseur étant supérieures à la pression et à la température du réfrigérant (40) à l'entrée (91) du compresseur (90) ;
- le réfrigérant (40) atteint l'entrée (52) du condenseur (50) à travers le deuxième conduit ou tube (76) où il passe de l'état gazeux (42) à l'état liquide (44) à la sortie (54) du condenseur.
